# EUROPÄISCHE PATENTSCHRIFT

(11) **EP 1 808 061 B1**
(45) Veröffentlichungstag und Bekanntmachung des Hinweises auf die Patenterteilung: **05.03.2008**
(21) Anmeldenummer: 05794679.0
(22) Anmeldetag: 30.09.2005
(51) Int. Cl.: H05K 13/04

(54) **BELEUCHTUNGSANORDNUNG UND OPTISCHES MESSSYSTEM ZUM ERFASSEN VON OBJEKTEN**
LIGHTING ARRAY AND OPTICAL MEASURING SYSTEM FOR DETECTING OBJECTS
DISPOSITIF D'ECLAIRAGE ET SYSTEME DE MESURE OPTIQUE POUR LA DETECTION D'OBJETS

(30) Priorität: 02.11.2004 DE 102004052884
(43) Veröffentlichungstag der Anmeldung: 18.07.2007
(73) Patentinhaber: SIEMENS AKTIENGESELLSCHAFT, 80333 München (DE)
(72) Erfinder: STANZL, Harald, 81476 München (DE); BESCH, Karl-Heinz, 82140 Olching (DE); IHLEFELD, Joachim, 01097 Dresden (DE); VIETZE, Oliver, CH-8500 Frauenfeld (CH)
(86) Internationale Anmeldenummer: PCT/EP2005/054943
(87) Internationale Veröffentlichungsnummer: WO 2006/048360

(56) Entgegenhaltungen:
- EP-A- 0 994 328
- WO-A-98/41078
- WO-A-20/04052071
- DE-A1- 19 826 555

## Beschreibung

Die Erfindung betrifft eine Beleuchtungsanordnung mit einer Mehrzahl von in einer Beleuchtungsebene angeordneten Leuchtelementen zum Erzeugen einer Beleuchtungszeile auf einem zu erfassenden Objekt. Die Erfindung betrifft ferner ein optisches Meßsystem zum Erfassen von Objekten, insbesondere zum Erfassen eines von einer Haltevorrichtung eines Bestückkopfes aufgenommenen Bauelements mit einer oben genannten Beleuchtungsanordnung.

Die automatische Bestückung von Bauelementeträgern, welche insbesondere Leiterplatten oder sonstige Arten von im Elektronikbereich verwendete bestückfähige Substrate umfassen, erfolgt üblicherweise in so genannten Bestückautomaten. Dabei werden Bauelemente mittels eines Bestückkopfes von einer Bauelement-Zuführeinrichtung hin zu einer Bestückposition transportiert und auf dem Bauelementeträger an einem vorgesehenen Bauelement-Einbauplatz aufgesetzt. Aufgrund der zunehmenden Miniaturisierung von elektronischen Bauelementen beruht ein korrekter Bestückvorgang unter anderem auf einer präzisen Lagevermessung von dem aufzusetzenden Bauelement relativ zu dem Bestückkopf. Bei der Lagevermessung, bei der das Bauelement typischerweise auch auf mechanische Defekte hin untersucht wird, ist eine optimale Beleuchtung des Bauelements ein wesentlicher Faktor für ein korrektes Vermessungsergebnis, welches wiederum eine zwingende Voraussetzung für eine präzise Bestückung mit einer niedrigen Fehlerrate ist. Eine fehlerhafte Bestückung liegt insbesondere dann vor, wenn die Anschlüsse des aufgesetzten Bauelements nicht exakt auf den auf der Leiterplatte vorgesehenen Anschlussflächen liegen.

Bei der Erfassung von Bauelementen mittels Kameras, welche typischerweise einen flächigen CCD Sensor (Charged Coupled Device Sensor) aufweisen, werden zur Beleuchtung Lichtzeilen verwendet, die symmetrisch zu allen vier Seiten des zu erfassenden Bauelements angeordnet sind. Die Lichtzeilen umfassen jeweils eine Mehrzahl von nebeneinander angeordneten Lichtquellen. Auf diese Weise wird eine relativ homogene Beleuchtung des Bauelements erreicht.

Bei Verwendung eines so genannten Pick & Place Bestückkopfes, welcher die Bauelemente von einer Bauelement-Zuführeinrichtung hin zu der Bestückposition transportiert, ergibt sich der Nachteil, dass zur Vermessung der Bestückkopf mit dem aufgenommenen Bauelement oberhalb der Kamera positioniert werden und während der für die Bauelementevermessung benötigten Zeitspanne an dieser Stelle verweilen muss. Somit wird die Bewegung des Bestückkopfes durch die Bauelementvermessung unterbrochen, so dass die Bestückleistung, d.h. die Anzahl an Bauelementen, die innerhalb einer bestimmten Zeit von der Bauelement-Zuführeinrichtung abgeholt, optisch vermessen und an einer entsprechenden Bestückposition aufgesetzt werden, entsprechend reduziert wird.

Der Nachteil der reduzierten Bestückleistung kann durch die Verwendung von Zeilenkameras vermieden werden, welche die Bauelemente durch eine sequentielle Aufnahme von einer Vielzahl von Bildzeilen erfasst. Dabei wird das Bauelement relativ zu der Zeilenkamera entlang einer Bewegungsrichtung verfahren, welche senkrecht zu der Längsrichtung des verwendeten Zeilensensors verläuft. Der Bestückkopf muss somit zur Bauelementvermessung nicht angehalten werden, so dass bei einer entsprechenden Orientierung des Zeilensensors relativ zu dem üblichen Verfahrweg des Bestrückkopfes die Zeitspanne vom Abholen des Bauelements bis hin zum Aufsetzen des Bauelements entsprechend verkürzt werden kann.

Die Verwendung von Zeilenkameras hat jedoch den Nachteil, dass herkömmliche, üblicherweise quadratische Beleuchtungsanordnungen nicht geeignet sind, da diese üblicherweise eine quadratische Fläche ausleuchten und somit ein hoher Prozentsatz der erzeugten Lichtmenge nicht genutzt wird. Da für eine zügige Bauelementvermessung mittels einer Zeilenkamera kurze Belichtungszeiten für jeweils eine Bildzeile erforderlich sind, benötigen Zeilenkameras für eine ausreichende Beleuchtung eine hohe Lichtintensität innerhalb einer Beleuchtungszeile, in welcher sich das zu erfassende Bauelement befindet.

Als relevanter Stand der Technik ist die in WO 98/41078 angegebene Beleuchtungsanordnung anzusehen.

Der Erfindung liegt die Aufgabe zugrunde, eine Beleuchtungsanordnung zu schaffen, welche eine zuverlässige und schnelle Vermessung eines Objekts mittels einer Zeilenkamera ermöglicht. Der Erfindung liegt die weitere Aufgabe zugrunde, ein optisches Meßsystem zum zuverlässigen und schnellen Erfassung von Objekten, insbesondere von elektronischen Bauelementen zu schaffen.

Die erste Aufgabe wird gelöst durch eine Beleuchtungsanordnung insbesondere zum Beleuchten eines von einer Haltevorrichtung eines Bestückkopfes aufgenommenen Bauelements mit den Merkmalen des unabhängigen Anspruchs 1. Gemäß der Erfindung umfasst die Beleuchtungsanordnung eine Mehrzahl von Leuchtelementen, welche in einer Beleuchtungsebene angeordnet sind und welche zum Beleuchten einer parallel zu der Beleuchtungsebene orientierten Beleuchtungszeile eingerichtet sind. Die Leuchtelemente sind in zwei Gruppen angeordnet. Eine erste Gruppe von ersten Leuchtelementen bildet dabei eine erste Lichtzeile und eine zweite Gruppe von zweiten Leuchtelementen bildet eine zweite Lichtzeile. Die beiden Lichtzeilen, welche mit einem Parallelversatz voneinander beabstandet und parallel zu der Beleuchtungszeile ausgerichtet sind, sind ferner symmetrisch zu der Beleuchtungszeile derart angeordnet, dass die auf die Beleuchtungszeile treffenden Lichtstrahlen der ersten Leuchtelemente in einer erste Einfallsebene und die auf die Beleuchtungszeile treffenden Lichtstrahlen der zweiten Leuchtelemente in einer zweiten Einfallsebene liegen, welche winklig zu der ersten Einfallsebene orientiert ist.

Der Erfindung liegt die Erkenntnis zugrunde, dass eine effiziente Beleuchtung einer Beleuchtungszeile durch zwei Lichtzeilen erreicht werden kann, welche parallel zu der Beleuchtungszeile ausgerichtet sind und welche diese Beleuchtungszeile unter jeweils einem schrägen Winkel beleuchten. Unter dem Begriff Leuchtelement ist erfindungsgemäß jede Art von Element zu verstehen, welches zum Aussenden von Licht eingerichtet ist. Insbesondere eignen sich als Leuchtelemente Leuchtdioden, welche nicht nur preiswert sind, sondern auch noch eine lange Lebensdauer und einen geringen Stromverbrauch aufweisen.

Die Beleuchtungsanordnung nach Anspruch 2 hat den Vorteil, dass die auf die Beleuchtungszeile treffende Lichtintensität optimal angepasst werden kann. Somit kann die Beleuchtungsverteilung innerhalb der Beleuchtungszeile beispielsweise für unterschiedliche zu vermessende Bauelemente jeweils optimal angepasst werden. Zudem kann auch eine insbesondere durch eine Alterung von einzelnen Leuchtelementen verursachte inhomogenen Beleuchtungsverteilung durch eine entsprechende stärkere Ansteuerung von schwächeren Leuchtelementen derart geändert werden, dass über einen langen Zeitraum eine homogene Beleuchtungsverteilung gewährleistet ist. Eine einfach zu realisierende und trotzdem noch effektive Ansteuerung wird durch eine Beleuchtungsanordnung realisiert, bei der mehrere Leuchtelemente jeweils gemeinsam ansteuerbar sind.

Gemäß Anspruch 3 werden die Leuchtelemente durch die Enden von Lichtwellenleitern realisiert, so dass die Leuchtelemente besonders nahe an das zu vermessende Objekt herangeführt werden können. Somit kann die Beleuchtungsanordnung sowohl eine hohe effektive Lichtintensität erzeugen als auch innerhalb eines kompakten Aufbaus realisiert werden. Bevorzugt erfolgt die Einspeisung des Beleuchtungslichts in den Lichtwellenleiter durch eine Kombination einer mehrere Leuchtdioden aufweisenden Baugruppe mit einer entsprechenden Anzahl von Lichtwellenleitern.

Die Beleuchtungsanordnung nach Anspruch 4 hat den Vorteil, dass lediglich eine geringe oder gar keine Lichtintensität auf Bereiche außerhalb der Beleuchtungszeile gerichtet wird und somit das erzeugte Beleuchtungslicht optimal zur Beleuchtung der Beleuchtungszeile ausgenutzt wird. Die Verwendung einer entsprechend angepassten Optik hat zudem den Vorteil, dass innerhalb der Beleuchtungszeile eine zumindest annähernd konstante Verteilung der Lichtintensität realisiert werden kann.

Die Verwendung einer Stablinse gemäß Anspruch 5 hat den Vorteil, dass ein entsprechendes mehrere Stablinsen aufweisendes Linsensystem kompakt aufgebaut werden kann und zudem eine einfache Handhabung und Justierung der Stablinsenanordnung möglich ist. Im Zusammenhang mit dem Einsatz von Lichtwellenleitern haben Stablinsen den Vorteil, dass zwei oder mehrere Lichtwellenleiter mit einer einzigen Stablinse optisch gekoppelt werden können, so dass die Stablinse eine gemeinsame Optik für zwei oder mehrere Lichtwellenleiter darstellt und somit einen noch kompakteren Aufbau der Beleuchtungsanordnung ermöglicht.

Die Verwendung einer telezentrischen Optik gemäß Anspruch 6 hat den Vorteil, dass die resultierende Beleuchtungsstärke innerhalb eines besonders großen Tiefenschärfebereichs einer verwendeten Zeilenkamera weitgehend konstant ist und somit eine Beleuchtung ermöglicht, die eine besonders zuverlässige Vermessung von Objekten ermöglicht. Durch eine entsprechende Formung der Lichtaustrittsfläche kann die telezentrische Optik in den Lichtwellenleiter oder in eine Stablinse integriert sein. Ein weiterer Vorteil bei der Verwendung von telezentrischen Optiken besteht darin, dass innerhalb der Beleuchtungszeile eine besonders homogene Lichtverteilung erzielt werden kann.

Die Beleuchtungsanordnung nach Anspruch 7 bewirkt eine Beleuchtung eines zu erfassenden Objekts unter einem flachen Winkel, so dass bei einer unmittelbar oberhalb der Beleuchtungszeile angeordneten Zeilenkamera eine Dunkelfeldbeleuchtung realisiert ist, welche auf vorteilhafte Weise eine weitgehend reflexionsfreie Erfassung des vermessenden Objekts ermöglicht.

Die Beleuchtungsanordnung nach Anspruch 8 erlaubt eine homogene Beleuchtung aus verschiedenen Beleuchtungsrichtungen innerhalb der jeweiligen Einfallsebene. Damit können insbesondere die Anschlusskugeln von flächigen Bauelementen - so genannten Ball Grid Arrays - mit einer höheren Genauigkeit vermessen werden, da die Kontor der Anschlusskugeln aus mehreren unterschiedlichen Richtungen beleuchtet wird.

Die Beleuchtungsanordnung nach Anspruch 9 hat den Vorteil, dass die Asymmetrie der Beleuchtung, die durch die parallele Anordnung der Beleuchtungszeilen verursacht wird, in der Beleuchtungsverteilung sehr schwach und insbesondere bei einem Winkel von 90° vollständig eliminiert ist.

Bei der Beleuchtungsanordnung nach Anspruch 10 können die Leuchtelemente besonders nahe an die Beleuchtungszeile herangeführt werden, so dass ein hohe Beleuchtungsintensität erzielbar ist.

Die zweite der Erfindung zugrunde liegende Aufgabe wird gelöst durch ein optisches Meßsystem zum Erfassen von Objekten, insbesondere zum Erfassen eines von einer Haltevorrichtung eines Bestückkopfes aufgenommenen Bauelements mit den Merkmalen des unabhängigen Anspruchs 11. Das erfindungsgemäße optische Meßsystem umfasst neben einer Beleuchtungsanordnung nach einem der Ansprüche 1 bis 10 noch einen Zeilensensor, mittels welchem derjenige Teil eines Objektes erfasst werden kann, welcher durch die Beleuchtungszeile erhellt wird. Das optische Meßsystem ermöglicht durch die für einen Zeilensensor optimierte Beleuchtung eine schnelle sequentielle Bildaufnahme des zu erfassenden Objekts, bei der durch eine Relativbewegung zwischen Objekt und Zeilenkamera, welche senkrecht zu der Längsrichtung des Zeilensensors verläuft, nacheinander eine Mehrzahl von Bildzeilen aufgenommen werden. Die aufgenommenen Bildzeilen werden in einer Auswerteeinheit zu einem Gesamtbild des Objekts zusammengesetzt und können mittels einer geeigneten Bildverarbeitung in bekannter Weise weiterverarbeitet werden.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen:
- Figur 1: eine Draufsicht einer Beleuchtungsanordnung, bei der die für die Beleuchtung verwendeten Leuchtelemente durch Lichtwellenleiter-Endflächen realisiert sind,
- Figur 2: eine Seitenansicht der in Figur 1 dargestellten Beleuchtungsanordnung und
- Figur 3: die kompakte Realisierung zweier Leuchtelemente mittels einer mit zwei Lichtwellenleitern optisch gekoppelten Stablinse.

An dieser Stelle bleibt anzumerken, dass sich in der Zeichnung die Bezugszeichen einander entsprechender Komponenten lediglich in ihrer ersten Ziffer unterscheiden.

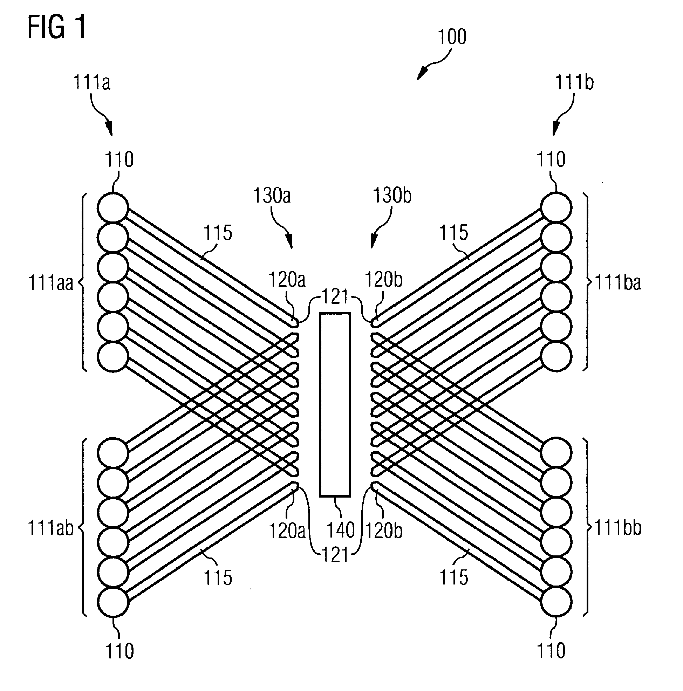

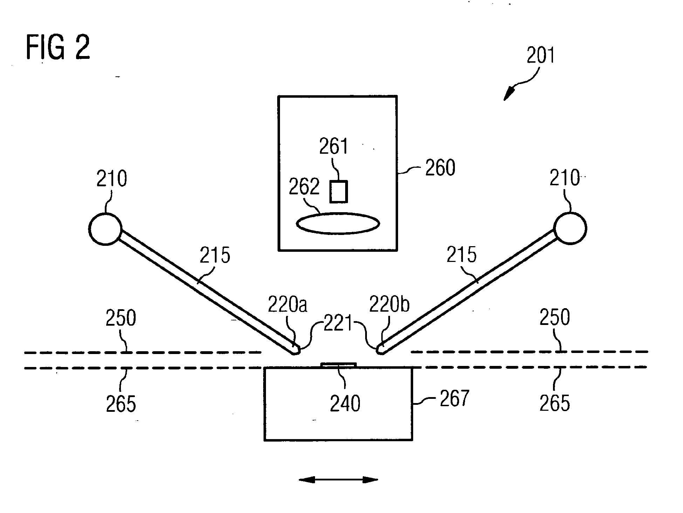

Wie aus Figur 1 ersichtlich, umfasst eine Beleuchtungsanordnung 100 eine Mehrzahl von Leuchtdioden 110, welche jeweils mit einem Lichtwellenleiter 115 optisch gekoppelt sind. Die Leuchtdioden 110 sind in zwei Gruppen, in eine erste Gruppe 111a und in eine zweite Gruppe 111b aufgeteilt. Die Endflächen der Lichtwellenleiter 115 stellen jeweils ein Leuchtelement dar. Die Leuchtelemente sind entsprechend der Aufteilung der Leuchtdioden 110 ebenfalls in zwei Gruppen, in eine Gruppe von ersten Leuchtelementen 120a und in eine Gruppe von zweiten Leuchtelementen 120b aufgeteilt. Die Licht aussendenden Endflächen der Lichtwellenleiter 115 sind derart gekrümmt, dass die Endflächen jeweils eine fokussierende Optik 121 darstellen. Die Optiken 121 können eine telezentrische Geometrie aufweisen, so dass eine Fokussierung mit einer besonders hohen Tiefenschärfe möglich ist. Die Lichtwellenleiter-Endflächen, welche die ersten Leuchtelemente 120a darstellen, sind entlang einer geraden Linie angeordnet und bilden somit eine erste Lichtzeile 130a. Entsprechendes gilt für die zweiten Leuchtelemente 120b, die eine parallel zu der ersten Lichtzeile 130a verlaufende zweite Lichtzeile 130b bilden. Die Leuchtelemente 120a bzw. 120b der beiden Lichtzeilen 130a bzw. 130b emittieren ein Beleuchtungslicht, welches innerhalb einer Beleuchtungszeile 140 eine Oberfläche eines in Figur 1 nicht dargestellten Objekts beleuchtet. Die von den beiden Lichtzeilen 130a bzw. 130b ausgesandten Lichtstrahlen verlaufen jeweils in einer Einfallsebene, welche durch die Längsachse der Beleuchtungszeile 140 und durch die erste Lichtzeile 130a bzw. durch die zweite Lichtzeile 130b festgelegt ist. Auf diese Weise wird eine Beleuchtung einer in Figur 1 nicht dargestellten Objektoberfläche unter einem flachen Winkel realisiert. Diese flache Beleuchtung ist aus der in Figur 2 dargestellten Seitenansicht eines optischen Meßsystems 101 zu erkennen, welches die Beleuchtungsanordnung 100 umfasst.

Wie aus Figur 2 ersichtlich, liegen die entlang der beiden Lichtzeilen angeordneten Leuchtelemente 220a bzw. 220b in einer Beleuchtungsebene 250, welche sich oberhalb einer Objektebene 265 einer Zeilenkamera 260 befindet. Die Zeilenkamera 260 weist einen Zeilensensor 261 und eine Abbildungsoptik 262 auf. Zur Erfassung einer Oberfläche eines Objekts 267 wird das Objekt 267 derart positioniert, dass die Oberfläche des Objekts 267 in der Objektebene 265 liegt. Die Beleuchtung des Objekts 267 erfolgt innerhalb einer Beleuchtungszeile 240. Das von Leuchtdioden 210 erzeugte Beleuchtungslicht wird über Lichtwellenleiter 215 in die Nähe der Beleuchtungszeile 240 geführt, wobei die Endflächen der Lichtwellenleiter 215 die ersten Leuchtelemente 220a bzw. die zweiten Leuchtelemente 220b darstellen. Das von den Leuchtelementen 220a bzw. 220b ausgesandte Beleuchtungslicht ist aufgrund der durch eine entsprechende Bearbeitung der Lichtwellenleiter-Endflächen derart gekrümmt, dass die Lichtwellenleiter-Endflächen zusätzlich eine fokussierende Optik 221 darstellen. Diese Optiken bewirken eine Fokussierung des Beleuchtungslichts auf die Beleuchtungszeile 240, so dass nahezu sämtliche von den Leuchtdioden 210 erzeugte Lichtintensität auf die Beleuchtungszeile 240 trifft.

Zur Vermessung der Objekt-Oberfläche wird das Objekt 267 entlang des dargestellten Doppelpfeiles bewegt und dabei durch die Zeilenkamera 260 nacheinander eine Mehrzahl von quasi eindimensionalen Bildern aufgenommen, welche in bekannter Weise zu einem Gesamtbild der Oberfläche des Objekts 267 zusammengesetzt werden können.

Die Beleuchtung der Oberfläche des Objekts 267 unter einem flachen Beleuchtungswinkel, welcher zum einen durch den horizontalen Abstand der ersten Leuchtelemente 220a bzw. der zweiten Leuchtelemente 220b von der Beleuchtungszeile 240 und zum anderen von dem vertikalen Abstand zwischen der Beleuchtungsebene 250 und der Objektebene 265 abhängt, hat den Vorteil, dass die durch Lichtwellenleiter-Endflächen realisierten Leuchtelemente 220a bzw. 220b nahe an die zu vermessende Oberfläche des Objekts 267 herangeführt werden können. Dies ermöglicht die Erzeugung einer besonders hohen Lichtintensität innerhalb der Beleuchtungszeile 240, welche den Vorteil hat, dass die Belichtungszeit zur Aufnahme eines Zeilenbildes und damit auch die Zeitdauer für die gesamte Vermessung der Objektoberfläche kurz gehalten werden kann. Die flache Beleuchtung hat ferner den Vorteil, dass eine für eine präzise Objektvermessung vorteilhafte Dunkelfeldbeleuchtung realisiert ist.

An dieser Stelle wird darauf hingewiesen, dass auch mehr als zwei Einfallsebenen vorgesehen sein können, so dass bei Bedarf unterschiedlich steile Beleuchtungen realisiert werden können. So können beispielsweise drei Paare von jeweils symmetrisch zu der optischen Achse der Kamera 260 angeordnete Lichtzeilen vorgesehen sein, deren Einfallsebenen jeweils einen Winkel von 60°, 120° und 160° einschließen. Ebenso können beweglich angeordnete Lichtzeilen verwendet werden, so dass der Winkel, den zwei Einfallsebenen einschließen, innerhalb eines weiten Winkelbereiches variiert werden kann.

Wie ferner aus Figur 1 ersichtlich, sind die beiden Gruppen von Leuchtdioden 111a bzw. 111b jeweils in zwei Untergruppen, 111aa und 111ab bzw. 111ba und 111bb aufgeteilt. Innerhalb einer Einfallsebene führen die Leuchtelemente, die über Lichtwellenleiter 115 bestimmten Leuchtdioden 110 aus unterschiedlichen Untergruppen zugeordnet sind, zu einer Beleuchtung, die innerhalb der jeweiligen Einfallsebene zwei aus unterschiedlichen Richtungen erfolgt. Dies hat den Vorteil, dass beispielsweise die Anschlusskugeln von so genannten Ball Grid Arrays mit einer höheren Genauigkeit vermessen werden können, da die Kontor der Anschlusskugeln aus mehreren unterschiedlichen Richtungen beleuchtet wird. Ein weiterer Vorteil besteht darin, dass die Asymmetrie der Beleuchtung reduziert und insbesondere bei einem Winkel von ungefähr 90° zwischen zwei verschieden Einfallsrichtungen nahezu vollständig eliminiert ist.

Es wird darauf hingewiesen, dass die Leuchtdioden 110 auch in mehr als zwei Untergruppen aufgeteilt sein können, welche Beleuchtungslicht emittieren, das über entsprechende angeordnete und ausgerichtete Leuchtelemente innerhalb einer Einfallsebene aus mehr als aus zwei Einfallsrichtungen auf die Beleuchtungszeile trifft.

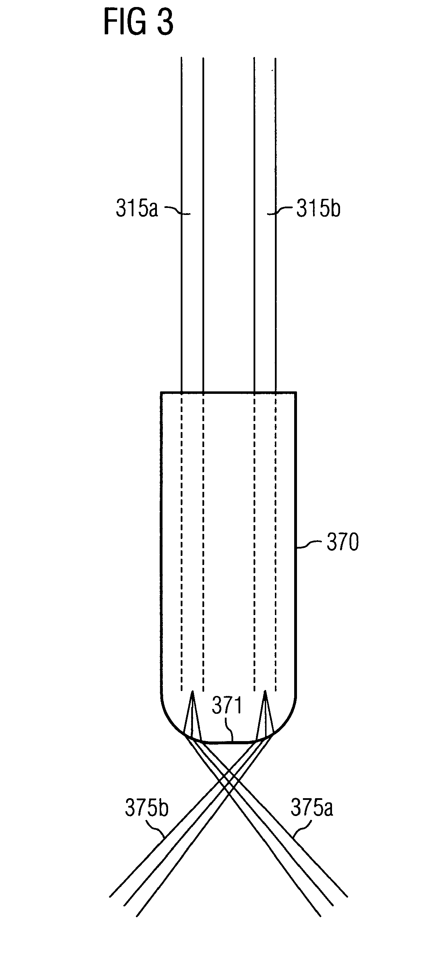

Figur 3 zeigt eine bevorzugte Realisierung zweier Leuchtelemente mittels einer Stablinse 370, welche mit zwei Lichtwellenleitern 315 und 315b optisch gekoppelt ist. Die Lichtwellenleiter 315a und 315b führen das Beleuchtungslicht bis in die Nähe einer Austrittsfläche 371 der Stablinse 370. Die aus den Enden der beiden Lichtwellenleiter 315a und 315b austretenden Lichtstrahlen 375a bzw. 375b werden an der eine optische Grenzfläche darstellende Austrittsfläche 371 entsprechend des Brechungsgesetzes von Snellius abgelenkt, so dass die Lichtstrahlen 375a bzw. 375b die Beleuchtungszeile 140 aus unterschiedlichen Beleuchtungsrichtungen beleuchten. Der von den Lichtstrahlen 375a und 375b eingeschlossene Winkel ist durch die Krümmung der Austrittsfläche 371, durch den Brechungsindex des Materials der Stablinse 370 und durch den Abstand der parallel angeordneten Lichtwellenleiter 315a und 315b innerhalb der Stablinse 370 bestimmt. Die Realisierung zweier Leuchtelemente mittels einer Stablinse 370 hat den Vorteil, dass die Leuchtelemente besonders nahe an der Beleuchtungszeile 140 angeordnet sein können und somit eine hohe Beleuchtungsintensität innerhalb eines kompakten optischen Aufbaus realisiert werden kann. Die Austrittsfläche 371 dient dabei als gemeinsame Optik für zwei Leuchtelemente.

Die Kopplung einer Stablinse mit zwei unterschiedlichen Untergruppen zugeordneten Lichtwellenleitern hat den Vorteil, dass für jede Einfallsebene nur eine Gruppe von Stablinsen benötigt wird. Eine derartige Gruppe von Stablinsen kann einstückig ausgebildet sein. Dies schafft die Möglichkeit, die Beleuchtungsanordnung innerhalb einer besonders kompakten Bauform zu realisieren und die Leuchtelemente nahe an die Beleuchtungszeile heranzuführen. Die Verwendung einstückig ausgebildeter Mehrfachstablinsen ist auch dann von Vorteil, wenn innerhalb eines kompakten Aufbaus mehr als jeweils zwei Untergruppen von Leuchtdioden vorgesehen sind, um innerhalb einer Einfallsebene die Beleuchtungszeile aus mehr als einer Richtung zu beleuchten.

### Bezugszeichenliste

- 100: Beleuchtungsanordnung
- 110: Leuchtdiode
- 111a: erste Gruppe von Leuchtdioden
- 111b: zweite Gruppe von Leuchtdioden
- 111aa: erste Untergruppe
- 111ab: zweite Untergruppe
- 111ba: erste Untergruppe
- 111bb: zweite Untergruppe
- 115: Lichtwellenleiter
- 120a: erstes Leuchtelement / Lichtwellenleiter-Endfläche
- 120b: zweites Leuchtelement / Lichtwellenleiter-Endfläche
- 121: Optik (in Lichtwellenleiter integriert)
- 130a: erste Lichtzeile
- 130b: zweite Lichtzeile
- 140: Beleuchtungszeile

- 201: Optisches Messsystem
- 210: Leuchtdiode
- 215: Lichtwellenleiter
- 220a: erstes Leuchtelement / Lichtwellenleiter-Endfläche
- 220b: zweites Leuchtelement / Lichtwellenleiter-Endfläche
- 221: Optik (in Lichtwellenleiter integriert)
- 240: Beleuchtungszeile
- 250: Beleuchtungsebene
- 260: Zeilenkamera
- 261: Zeilensensor
- 262: Abbildungsoptik
- 265: Objektebene
- 267: Objekt

- 315a: Lichtwellenleiter
- 315b: Lichtwellenleiter
- 370: Stablinse
- 371: Austrittsfläche
- 375a: Lichtstrahlen
- 375b: Lichtstrahlen

## Patentansprüche

1. Beleuchtungsanordnung, insbesondere zum Beleuchten eines von einer Haltevorrichtung eines Bestückkopfes aufgenommenen Bauelementes, mit
einer Mehrzahl von in einer Beleuchtungsebene (250) angeordneten Leuchtelementen (120a, 120b, 220a, 220b), welche zum Beleuchten einer parallel zu der Beleuchtungsebene (250) orientierten Beleuchtungszeile (140, 240) eingerichtet sind, wobei die Leuchtelemente (120a, 120b, 220a, 220b) in zwei Gruppen derart angeordnet sind, dass
**•** eine erste Gruppe von ersten Leuchtelementen (120a, 220a) entlang einer ersten Lichtzeile (130a) und eine zweite Gruppe von zweiten Leuchtelementen (120b, 220b) entlang einer zweiten Lichtzeile (130b) angeordnet sind,
**•** die beiden Lichtzeilen (130a, 130b) mit einem Parallelversatz voneinander beabstandet parallel zu der Beleuchtungszeile (140, 240) ausgerichtet sind, und
**•** die beiden Lichtzeilen (130a, 130b) symmetrisch zu der Beleuchtungszeile (140, 240) angeordnet sind, so dass auf die Beleuchtungszeile (140, 240) treffende Lichtstrahlen der ersten Leuchtelemente (120a, 220a) in einer ersten Einfallsebene und
auf die Beleuchtungszeile (140, 240) treffende Lichtstrahlen der zweiten Leuchtelemente (120b, 220b) in einer zweiten Einfallsebene liegen.

2. Beleuchtungsanordnung nach Anspruch 1, bei der
zumindest einige der Leuchtelemente (120a, 120b, 220a, 220b) individuell ansteuerbar sind.

3. Beleuchtungsanordnung nach einem der Ansprüche 1 bis 2, bei der
jeweils ein Leuchtelement (120a, 120b, 220a, 220b) eine Endfläche eines Lichtwellenleiters (115, 215) ist.

4. Beleuchtungsanordnung nach einem der Ansprüche 1 bis 3, bei der
die Leuchtelemente (120a, 120b, 220a, 220b) jeweils eine Optik (121, 221) zur Fokussierung der ausgesandten Lichtstrahlen auf die Beleuchtungszeile (140, 240) aufweisen.

5. Beleuchtungsanordnung nach Anspruch 4, bei der
die Optik (121, 221) eine Stablinse (370) ist.

6. Beleuchtungsanordnung nach einem der Ansprüche 4 bis 5, bei der
die Optik (121, 221) eine telezentrische Optik ist.

7. Beleuchtungsanordnung nach einem der Ansprüche 1 bis 6, bei der
die erste Einfallsebene und die zweite Einfallsebene einen Winkel von 110° bis 160°, bevorzugt von 125° bis 145° und weiter bevorzugt von 135° einschließen.

8. Beleuchtungsanordnung nach einem der Ansprüche 1 bis 7, bei der
jede Gruppe von Leuchtelementen (120a bzw. 120b) zumindest eine erste Untergruppe und eine zweite Untergruppe von Leuchtelementen aufweist, wobei die den unterschiedlichen Untergruppen zugeordneten Leuchtelemente die Beleuchtungszeile (140) aus unterschiedlichen Richtungen beleuchten.

9. Beleuchtungsanordnung nach Anspruch 8, bei der
die Projektionen der Lichtstrahlen von unterschiedlichen Untergruppen zugeordneten Leuchtelementen (120a bzw. 120b) auf eine die Beleuchtungszeile (140) umfassende Objektebene (265) einen Winkel von 65° bis 115°, bevorzugt von 80° bis 100° und weiter bevorzugt von 90° einschließen.

10. Beleuchtungsanordnung nach einem der Ansprüche 8 bis 9, bei der
jeweils ein Leuchtelement der ersten Untergruppe und ein Leuchtelement der zweiten Untergruppe mittels einer einzigen Stablinse (370) realisiert ist, welche mit zwei Lichtwellenleitern (315a und 315b) optisch derart gekoppelt ist, dass über unterschiedliche Lichtwellenleiter (315a und 315b) in die Stablinse (370) eingekoppeltes Beleuchtungslicht die Beleuchtungszeile (140) aus unterschiedlichen Beleuchtungsrichtungen beleuchtet.

11. Optisches Messsystem zum Erfassen von Objekten, insbesondere zum Erfassen eines von einer Haltevorrichtung eines Bestückkopfes aufgenommenen Bauelementes, mit
**•** einer Beleuchtungsanordnung (100) nach einem der Ansprüche 1 bis 10 und
**•** einem Zeilensensor (261), welche relativ zu der Beleuchtungsanordnung (100) derart angeordnet ist, dass ein Teil eines Objektes (267) erfassbar ist, welcher Teil sich in der Beleuchtungszeile (140, 240) befindet.

## Claims

1. Lighting array, in particular for illuminating a component picked by a holding device of a placement head, having a plurality of light-emitting elements (120a, 120b, 220a, 220b) which are arranged in an illumination plane (250) and are configured for the purpose of illuminating an illumination line (140, 240) orientated parallel to the illumination plane (250), with the light-emitting elements (120a, 120b, 220a, 220b) being arranged in two groups such that
• a first group of first light-emitting elements (120a, 220a) is arranged along a first row of lights (130a) and a second group of second light-emitting elements (120b, 220b) is arranged along a second row of lights (130b),
• the two rows of lights (130a, 130b) are aligned spaced apart with a parallel offset from each other and parallel to the illumination line (140, 240), and
**•** the two rows of lights (130a, 130b) are arranged symmetrically with respect to the illumination line (140, 240) such that light beams of the first light-emitting elements (120a, 220a) impinging on the illumination line (140, 240) lie in a first plane of incidence and light beams of the second light-emitting elements (120b, 220b) impinging on the illumination line (140, 240) lie in a second plane of incidence.

2. Lighting array according to claim 1, wherein
at least some of the light-emitting elements (120a, 120b, 220a, 220b) can be controlled individually.

3. Lighting array according to one of claims 1 to 2, wherein
one light-emitting element (120a, 120b, 220a, 220b) in each case is an end surface of an optical waveguide (115, 215).

4. Lighting array according to one of claims 1 to 3, wherein
the light-emitting elements (120a, 120b, 220a, 220b) in each case have a lens system (121, 221) for focusing the emitted light beams onto the illumination line (140, 240).

5. Lighting array according to claim 4, wherein
the lens system (121, 221) is a rod lens (370).

6. Lighting array according to one of claims 4 to 5, wherein
the lens system (121, 221) is a telecentric lens system.

7. Lighting array according to one of claims 1 to 6, wherein
the first plane of incidence and the second plane of incidence enclose an angle of 110° to 160°, preferably of 125° to 145° and further preferably of 135°.

8. Lighting array according to one of claims 1 to 7, wherein
each group of light-emitting elements (120a or 120b) has at least a first subgroup and a second subgroup of light-emitting elements, with the light-emitting elements assigned to the different subgroups illuminating the illumination line (140) from different directions.

9. Lighting array according to claim 8, wherein
the projections of the light beams of light-emitting elements (120a or 120b) assigned to different subgroups onto an object plane (265) encompassing the illumination line (140) enclose an angle of 65° to 115°, preferably of 80° to 100° and further preferably of 90°.

10. Lighting array according to one of claims 8 to 9, wherein
a light-emitting element of the first subgroup and a light-emitting element of the second subgroup are in each case implemented by means of a single rod lens (370) which is optically coupled to two optical waveguides (315a and 315b) in such a way that illumination light injected into the rod lens (370) via different optical waveguides (315a and 315b) illuminates the illumination line (140) from different illumination directions.

11. Optical measuring system for detecting objects, in particular for detecting a component picked by a holding device of a placement head, having
**•** a lighting array (100) according to one of claims 1 to 10 and
**•** a line sensor (261) which is arranged relative to the lighting array (100) such that a part of an object (267) can be detected, said part being located in the illumination line (140, 240).

## Revendications

1. Dispositif d'éclairage, en particulier pour l'éclairage d'un élément de construction réceptionné par un dispositif de retenue d'une tête d'équipement, comprenant
une pluralité d'éléments lumineux (120a, 120b, 220a, 220b) disposés dans un plan d'éclairage (250), qui sont aménagés pour l'éclairage d'une ligne d'éclairage (140, 240) orientée parallèlement au plan d'éclairage (250), les éléments lumineux (120a, 120b, 220a, 220b) étant disposés en deux groupes de telle sorte que
**•** un premier groupe de premiers éléments lumineux (120a, 220a) est disposé le long d'une première ligne de lumière (130a) et un second groupe de seconds éléments lumineux (120b, 220b), le long d'une seconde ligne de lumière (130b)
**•** les deux lignes de lumière (130a, 130b) étant orientées parallèlement à la ligne d'éclairage (140, 240), espacées l'une de l'autre avec un décalage parallèle, et
• les deux lignes de lumière (130a, 130b) sont disposées de façon symétrique par rapport à la ligne d'éclairage (140, 240), de sorte que des faisceaux de lumière, arrivant sur la ligne d'éclairage (140, 240), des premiers éléments lumineux (120a, 220a) sont disposés dans un premier plan d'incidence et des faisceaux de lumière, arrivant sur la ligne d'éclairage (140, 240), des seconds éléments lumineux (220a, 220b) sont disposés dans un second plan d'incidence.

2. Dispositif d'éclairage selon la revendication 1, dans lequel au moins certains des éléments lumineux (120a, 120b, 220a, 220b) peuvent être activés individuellement.

3. Dispositif d'éclairage selon l'une quelconque des revendications 1 à 2,
dans lequel
à chaque fois un élément lumineux (120a, 120b, 220a, 220b) est une surface d'extrémité d'un guide optique (115, 215).

4. Dispositif d'éclairage selon l'une quelconque des revendications 1 à 3,
dans lequel
les éléments lumineux (120a, 120b, 220a, 220b) présentent chacun une optique (121, 221) pour la focalisation des faisceaux de lumière émis sur la ligne d'éclairage (140, 240).

5. Dispositif d'éclairage selon la revendication 4, dans lequel l'optique (121, 221) est une lentille en forme de barre (370).

6. Dispositif d'éclairage selon l'une quelconque des revendications 4 à 5,
dans lequel
l'optique (121, 221) est une optique télécentrique.

7. Dispositif d'éclairage selon l'une quelconque des revendications 1 à 6,
dans lequel
le premier plan d'incidence et le second plan d'incidence forment un angle de 110° à 160°, de préférence de 125° à 145° et, avec une préférence supérieure, de 135°.

8. Dispositif d'éclairage selon l'une quelconque des revendications 1 à 7,
dans lequel
chaque groupe d'éléments lumineux (120a resp. 120b) présente au moins un premier sous-groupe et un second sous-groupe d'éléments lumineux, les éléments lumineux attribués aux différents sous-groupes éclairant la ligne d'éclairage (140) à partir de différentes directions.

9. Dispositif d'éclairage selon la revendication 8, dans lequel
les projections des faisceaux de lumière d'éléments lumineux (120a resp. 220b) attribués à différents sous-groupes sur un plan d'objet (265) comprenant la ligne d'éclairage (140) forment un angle de 65° à 115°, de préférence de 80° à 100° et, avec une préférence supérieure, de 90°.

10. Dispositif d'éclairage selon l'une quelconque des revendications 8 à 9,
dans lequel
à chaque fois un élément lumineux du premier sous-groupe et un élément lumineux du second sous-groupe sont réalisés au moyen d'une unique lentille en forme de barre (370), qui est couplée optiquement avec deux guides optiques (315a et 315b) de telle sorte que de la lumière d'éclairage injectée dans la lentille en forme de barre (370) au moyen de différents guides optiques (315a et 315b) éclaire la ligne d'éclairage (140) à partir de différentes directions d'éclairage.

11. Système de mesure optique pour la détection d'objets, en particulier pour la détection d'un élément de construction réceptionné par un dispositif de retenue d'une tête d'équipement, comprenant
**•** un dispositif d'éclairage (100) selon l'une quelconque des revendications 1 à 10 et
**•** un capteur de lignes (261), qui est disposé par rapport au dispositif d'éclairage (100) de telle sorte qu'une partie d'un objet (267), qui se trouve dans la ligne d'éclairage (140, 240), peut être détectée.
